# EUROPÄISCHE PATENTANMELDUNG

(11) **EP 3 988 398 A1**
(43) Veröffentlichungstag der Anmeldung: **27.04.2022**
(21) Anmeldenummer: 21201137.3
(22) Anmeldetag: 06.10.2021
(51) Int. Cl.: B60R 16/023, G07C 5/08, G07C 5/00, H03K 17/00

(54) **VERFAHREN ZUR ÜBERPRÜFUNG EINES FEHLERZUSTANDES EINER MOBILEN NUTZEINHEIT**

(30) Priorität: 21.10.2020 DE 102020127739
(71) Anmelder: Deere & Company, Moline, IL 61265 (US)
(72) Erfinder: FRITZ, Norbert, 68163 Mannheim (DE); KREMMER, Martin, 68163 Mannheim (DE)
(74) Vertreter: Dehnhardt, Florian Christopher

(57) **Zusammenfassung**

Die Erfindung betrifft ein Verfahren zur Überprüfung eines Fehlerzustandes (stat _F) einer mobilen Nutzeinheit (10) durch eine Wartungsstation (12). Einen Fehlerzustand (stat_F) der Nutzeinheit (10) repräsentierende Zustandsdaten (D_stat) werden generiert und als Fehlerdaten (D_F) abgespeichert. Die Fehlerdaten (D F) werden bezüglich unterschiedlicher Fehlerklassen (F1, F2, F3) klassifiziert. Anhand der Klassifizierung wird eine zutreffende Fehlerklasse (F1,F2, F3) ermittelt In Abhängigkeit von der ermittelten Fehlerklasse (F1,F2, F3) wird eine Verfahrensmaßnahme (M1, M2, M3, M4) für die Nutzeinheit (10) veranlasst.

## Beschreibung

Die Erfindung betrifft ein Verfahren zur Überprüfung eines Fehlerzustandes einer mobilen Nutzeinheit durch eine Wartungsstation.

Mobile Nutzeinheiten, wie z.B. land- oder forstwirtschaftliche Maschinen, werden üblicherweise in definierten Zeitintervallen gewartet und dabei auch hinsichtlich des aktuellen Zustandes verschiedener technischer Funktionen überprüft.

Der vorliegenden Erfindung liegt die Aufgabe zugrunde, eine Fehlerüberprüfung für eine mobile Nutzeinheit effizient durchzuführen.

Diese Aufgabe wird durch ein Verfahren mit den Merkmalen des Patentanspruchs 1 gelöst.

Weitere vorteilhafte Ausgestaltungen des erfindungsgemäßen Verfahrens gehen aus den Unteransprüchen hervor.

Das Verfahren gemäß Patentanspruch 1 dient der Überprüfung eines Fehlerzustandes einer mobilen Nutzeinheit durch eine Wartungsstation. Bei diesem Verfahren werden Zustandsdaten generiert, welche einen Fehlerzustand der Nutzeinheit repräsentieren. Vorzugsweise werden die Zustandsdaten in der Nutzeinheit selbst generiert. Die Zustandsdaten werden als Fehlerdaten abgespeichert. Die Fehlerdaten können mit den Zustandsdaten identisch sein oder von den Zustandsdaten (durch weitere Datenverarbeitung) abgeleitete Daten sein. Die Fehlerdaten können beispielsweise als spezifische Fehler-Codes abgespeichert werden.

Die Fehlerdaten werden bezüglich unterschiedlicher Fehlerklassen klassifiziert. Unter den bereitgestellten Fehlerklassen wird anhand der Klassifizierung eine für die jeweiligen Fehlerdaten zutreffende Fehlerklasse ermittelt. Mit anderen Worten werden spezifische Fehlerdaten analysiert und einer zutreffenden Fehlerklasse zugeordnet. Die unterschiedlichen Fehlerklassen sind vorzugsweise vor der Verfahrensdurchführung eindeutig definiert. Insbesondere wird vor der Verfahrensdurchführung (ggf. nach Art einer Kalibrierung) eine definierte Zuordnung theoretisch möglicher Fehlerzustände bzw. Fehlerdaten zu unterschiedlichen Fehlerklassen bereitgestellt. Während der Verfahrensdurchführung erfolgt dann die Klassifizierung auf Basis der bereitgestellten definierten Zuordnung.

In Abhängigkeit der ermittelten Fehlerklasse wird mindestens eine Verfahrensmaßnahme für die Nutzeinheit veranlasst.

Die vorgenannten Verfahrensschritte ermöglichen eine einfache Verfahrensstruktur, welche mit geringem datentechnischen Aufwand eine effiziente Überprüfung eines Fehlerzustandes an der Nutzeinheit bietet. Außerdem erlauben die vorgenannten Verfahrensschritte eine technisch einfache Automatisierung der gewünschten Fehlerüberprüfung. Somit ist mit dem Verfahren eine effiziente Fehlerdiagnose der Nutzeinheit möglich. Für eine Fehlerüberprüfung und die Veranlassung von geeigneten Verfahrensmaßnahmen herkömmlich herangezogenes Wartungspersonal kann entsprechend entlastet werden.

Die Veranlassung einer Verfahrensmaßnahme in Abhängigkeit von der ermittelten Fehlerklasse beinhaltet auch die Möglichkeit, dass bei mindestens einer ermittelten Fehlerklasse die Veranlassung einer Verfahrensmaßnahme unterbleibt. Vorteilhaft wird auf die Veranlassung einer Verfahrensmaßnahme dann verzichtet, wenn die ermittelte Fehlerklasse nur geringfügigen und für den Arbeitsbetrieb der Nutzeinheit unkritischen Fehlerzuständen entspricht und die Wartungsstation dann keine weitere Unterstützung mehr leisten muss.

Die Zustandsdaten werden vorzugsweise durch eine geeignete Elektronik, insbesondere Steuerelektronik, in der Nutzeinheit generiert. Diese Elektronik überwacht beispielsweise bestimmte Betriebszustände der Nutzeinheit und erkennt verschiedene fehlerhafte Betriebszustände als Fehlerzustände. Insbesondere werden in der Steuerelektronik auch die aus den Zustandsdaten resultierenden Fehlerdaten abgespeichert, z.B. in einem geeigneten Fehlerspeicher.

Vorzugsweise ist für die Verfahrensdurchführung mindestens eine der folgenden Fehlerklassen bereitgestellt:
F1) es ist keine fehlerbezogene Bearbeitung der Nutzeinheit erforderlich,
F2) eine fehlerbezogene Bearbeitung der Nutzeinheit durch die Wartungsstation ist erforderlich,
F3) eine fehlerbezogene Bearbeitung der Nutzeinheit durch Wartungspersonal ist erforderlich.

Die vorgenannte Fehlerklasse F1) ist beispielsweise dann zutreffend, wenn der festgestellte Fehlerzustand der Nutzeinheit für deren weiteren Arbeitsbetrieb unerheblich bzw. unkritisch ist.

Die vorgenannte Fehlerklasse F2) wird z.B. dann als zutreffend ermittelt, wenn der festgestellte Fehlerzustand in der und/oder durch die Wartungsstation bearbeitet werden kann. Ein solcher Fehlerzustand kann z.B. ein zu niedriges Flüssigkeitsniveau oder eine verschmutzte Sensorik sein. Derartige Fehlerzustände können in der Wartungsstation, insbesondere automatisiert durch die Wartungsstation selbst, bearbeitet und behoben werden.

Die vorgenannte Fehlerklasse F3) trifft vorzugsweise dann zu, wenn für die Bearbeitung und Behebung des Fehlerzustandes Wartungspersonal erforderlich ist. Fehlerzustände gemäß Fehlerklasse F3) können also nicht durch die Wartungsstation selbst oder zumindest nicht allein durch die Wartungsstation selbst behoben werden. Vielmehr wird die Unterstützung durch Wartungspersonal benötigt. Dies kann z.B. bei sehr komplexen Fehlerquellen und/oder schwer zugänglichen Fehlerquellen der Fall sein.

Vorteilhaft ist mindestens eine der folgenden Verfahrensmaßnahmen vorgesehen:
M1) die Nutzeinheit wird für einen weiteren Arbeitseinsatz freigegeben,
M2) der Fehlerzustand wird in der Wartungsstation und/oder durch die Wartungsstation bearbeitet,
M3) ein weiterer Arbeitseinsatz der Nutzeinheit wird blockiert.

Einzelne oder sämtliche vorgesehene Verfahrensmaßnahmen werden vorzugsweise durch die Wartungsstation veranlasst. Hierbei generiert und sendet die Wartungsstation beispielsweise spezifische Steuersignale an die Nutzeinheit, um letztere für einen weiteren Arbeitseinsatz freizugeben gemäß der Verfahrensmaßnahme M1). Dies ist beispielsweise bei der ermittelten Fehlerklasse F1) sinnvoll. Die Verfahrensmaßnahme M1) unterstützt insbesondere dann eine effiziente Wartung der Nutzeinheit, wenn diese als ein (teil-)autonomes Fahrzeug ausgebildet ist.

Bei einer weiteren Ausführungsform kann die Wartungsstation im Sinne der Verfahrensmaßnahme M2) eine automatisierte Maßnahme (z.B. zusätzliche Inspektion, Reparatur, Austausch von Bauteilen an der mobilen Nutzeinheit) aktivieren. Dies ist beispielsweise bei der ermittelten Fehlerklasse F2) sinnvoll.

Bei einer weiteren Ausführungsform kann die Wartungsstation im Sinne der Verfahrensmaßnahme M3) spezifische Steuersignale an die Nutzeinheit senden. Eine geeignete Steuerelektronik der Nutzeinheit kann dann in Abhängigkeit von derartigen Steuersignalen einen weiteren Betrieb bzw. Arbeitseinsatz der Nutzeinheit blockieren. Diese Verfahrensmaßnahme ist beispielsweise bei der ermittelten Fehlerklasse F3) sinnvoll. Vorzugsweise ist die Blockierung der Nutzeinheit durch eine Bedienungsperson (z.B. Fahrer, Anwender, Wartungspersonal) wieder aufhebbar.

Als Verfahrensmaßnahme ist es auch denkbar, dass die Wartungsstation eine Information ausgibt (z.B. optisch und/oder akustisch), welche insbesondere für einen Anwender, Fahrer oder Wartungspersonal bestimmt ist. Dies ist beispielsweise als zusätzliche Verfahrensmaßnahme sinnvoll, wenn die vorgenannte Verfahrensmaßnahme M3) veranlasst wird.

Vorzugsweise wird die Klassifizierung der Fehlerdaten und/oder die Veranlassung einer Verfahrensmaßnahme durch die Wartungsstation durchgeführt. Diese technische Ausgestaltung begrenzt vorteilhaft den apparativen Aufwand zur Durchführung des Verfahrens.

Weiter vorteilhaft werden die Fehlerdaten in einem Fehlerspeicher der Nutzeinheit abgespeichert und/oder in einer Datenverarbeitungseinheit der Wartungsstation klassifiziert. Diese elektrischen bzw. elektronischen Einheiten unterstützen eine effiziente Durchführung des Verfahrens. Die vorgenannte Datenverarbeitungseinheit enthält vorzugsweise sämtliche für eine Verarbeitung der Fehlerdaten erforderlichen Funktionen wie etwa einen Mikroprozessor, einen Speicher und insbesondere auch eine Datenbank zum Einlesen der Fehlerdaten sowie geeignete Algorithmen zur Analyse und Klassifizierung der Fehlerdaten.

Für eine effiziente Verfahrensdurchführung ist vorzugsweise ein automatisierter Datenaustausch zwischen der Nutzeinheit und der Wartungsstation vorgesehen. Dieser Datenaustausch ist insbesondere derart ausgebildet, dass die Nutzeinheit eine Datenschnittstelle zur Übertragung von generierten Fehlerdaten an die Wartungsstation aufweist und die Wartungsstation eine Kommunikationsschnittstelle zum Empfangen der Fehlerdaten aufweist. Vorzugsweise findet der Datenaustausch kabellos statt. Der Datenaustausch kann bidirektional, also nicht nur von der Nutzeinheit zu der Wartungsstation, ausgebildet sein. Der Datenaustausch kann abgesehen von den Fehlerdaten auch anderes Datenmaterial enthalten, z.B. relevante Betriebsdaten der Nutzeinheit, welche während des Arbeitsbetriebes der Nutzeinheit generiert worden sind.

Der vorgenannte Datenaustausch ist vorzugsweise mit einer Ver- und Entschlüsselung der Daten und mit einer Authentifizierung der Schnittstellen bzw. der Wartungsstation und der Nutzeinheit verbunden. Hierdurch wird die Datensicherheit und Zuverlässigkeit des Verfahrens erhöht.

Vorteilhaft wird die verfahrensgemäße automatisierte Fehlerüberprüfung in Anwendungsbereichen eingesetzt, in denen spezifische Automatisierungsfunktionen zur Effizienzsteigerung besonders geeignet sind, z.B. in großen landwirtschaftlichen Betrieben oder bei einer (teil-)autonomen Fahrzeugflotte.

Vorzugsweise handelt es sich bei der mobilen Nutzeinheit um ein Nutzfahrzeug (z.B. landwirtschaftliches Fahrzeug (z.B. Traktor) oder forstwirtschaftliches Fahrzeug, Baumaschine).

Das Nutzfahrzeug ist insbesondere als ein (teil-)autonomes Fahrzeug ausgebildet. Mit den offenbarten Verfahrensschritten lässt sich der Autonomisierungsgrad des Fahrzeugs effizient erhöhen.

Für die Wartungsstation kann es vorteilhaft sein, sie entweder vollständig stationär oder teilweise als eine mobile Wartungseinheit (neben einem stationären Teilbereich) oder vollständig als eine mobile Wartungseinheit auszugestalten. Die mobile Wartungseinheit kann luftgestützt (z.B. fliegende Drohne) und/oder landgestützt (z.B. beweglicher Roboterarm, fahrendes Service-Vehikel) sein. Eine zumindest teilweise mobile Wartungsstation kann unter bestimmten Rahmenbedingungen eine Fehlerüberprüfung der ausgewählten mobilen Nutzeinheit(en) noch effizienter und ökonomischer durchführen. Dies ist beispielsweise der Fall, wenn die Nutzeinheit Bestandteil einer Fahrzeugflotte ist, welche bezüglich des Zustands sämtlicher Flottenfahrzeuge überprüft werden soll.

Das erfindungsgemäße Verfahren wird im Folgenden anhand der beigefügten Zeichnung näher erläutert.

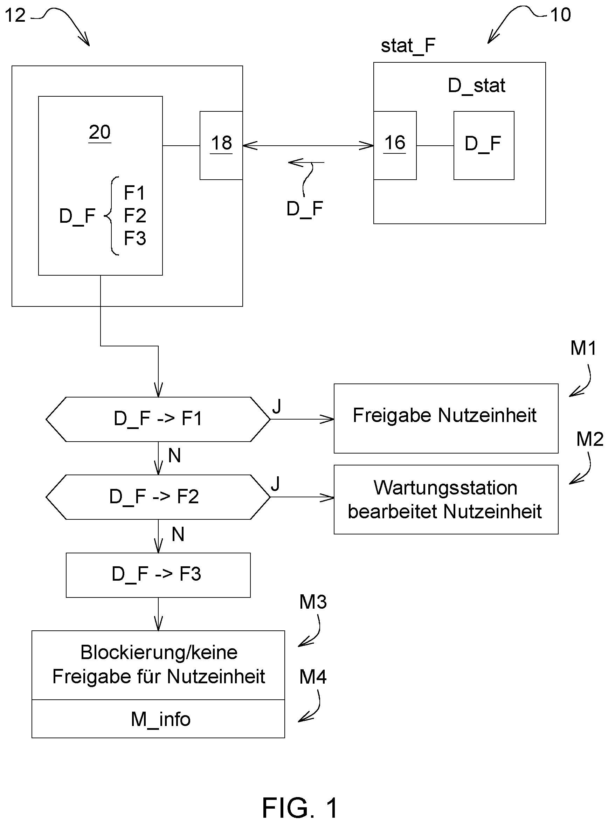

Fig. 1 zeigt schematisch eine mobile Nutzeinheit 10 und eine bezüglich der Nutzeinheit 10 externe Wartungsstation 12. Die Wartungsstation 12 dient zur Wartung der Nutzeinheit 10, insbesondere zur Überprüfung eines Fehlerzustandes der Nutzeinheit 10. Verschiedene Verfahrensschritte des Verfahrens zur Überprüfung des Fehlerzustandes sind in Fig. 1 in Form eines Flussdiagrammes dargestellt.

Die mobile Nutzeinheit 10 ist beispielsweise ein Nutzfahrzeug, insbesondere ein Traktor. Die Nutzeinheit 10 wird - entweder mit einem Fahrer oder als ein (teil-)autonomes Fahrzeug ohne Fahrer - zur Wartung und insbesondere zur Überprüfung eines Fehlerzustandes an die Wartungsstation 12 herangeführt.

In der Nutzeinheit 10 werden (z.B. mittels einer geeigneten Steuerelektronik) unterschiedliche Fehlerzustände stat_F erfasst und entsprechende Zustandsdaten D_stat generiert. Diese Zustandsdaten D_stat werden (nach optionaler Weiterverarbeitung) als Fehlerdaten D_F in einem Fehlerspeicher 14 der Nutzeinheit 10 abgespeichert.

Die Nutzeinheit 10 weist eine Datenschnittstelle 16 zur Übertragung der Fehlerdaten D_F an die Wartungsstation 12 auf. Die Übertragung der Fehlerdaten D_F wird datentechnisch beispielsweise von der Wartungsstation 12 angefordert. Letztere weist eine Kommunikationsschnittstelle 18 auf, welche die übertragenen Fehlerdaten D_F empfängt und ggf. auch für weiteren Datenaustausch zuständig ist.

Die Kommunikationsschnittstelle 18 ist mit einer Datenverarbeitungseinheit 20 verbunden, in der die empfangenen Fehlerdaten D_F bezüglich unterschiedlicher bereitgestellter Fehlerklassen F1, F2, F3 klassifiziert werden. Anhand dieser Klassifizierung wird die jeweiligen Fehlerdaten D_F zutreffende Fehlerklasse F1 oder F2 oder F3 ermittelt. Für die Analyse der Fehlerdaten D_F, deren Bewertung und die Klassifizierung weist die Verarbeitungseinheit 20 entsprechende Funktionalitäten auf, wie etwa einen Mikroprozessor, einen Speicher und/oder eine Datenbank und geeignete Algorithmen.

In Abhängigkeit von der ermittelten Fehlerklasse F1,F2,F3 wird durch die Wartungsstation 12 mindestens eine Verfahrensmaßnahme veranlasst. In dem Ausführungsbeispiel sind insgesamt vier verschiedene Verfahrensmaßnahmen M1, M2, M3, M4 offenbart.

Die Ermittlung der Fehlerklasse F1 bedeutet, dass eine fehlerbezogene Bearbeitung der Nutzeinheit 10 nicht erforderlich ist, d.h. der Fehlerstatus stat_F ist unkritisch. Die Wartungsstation 12 veranlasst deshalb eine Verfahrensmaßnahme M1, der zufolge die Nutzeinheit 10 durch die Wartungseinheit 12 für einen weiteren Arbeitseinsatz freigegeben wird, z.B. durch das Aussenden spezifischer Steuersignale an die Nutzeinheit 10.

Bei Ermittlung der Fehlerklasse F2 ist eine fehlerbezogene Bearbeitung der Nutzeinheit 10 durch die Wartungsstation 12 erforderlich. Die Wartungsstation 12 veranlasst dann die Verfahrensmaßnahme M2, wonach der Fehlerzustand stat_F in der Wartungsstation 12 und/oder durch die Wartungsstation 12 bearbeitet wird, z.B. Auffüllen eines (Betriebs-)Flüssigkeitsniveaus, Reinigen einer Sensorik, Erhöhen eines Reifendrucks.

Wird die Fehlerklasse F3 als zutreffend ermittelt, ist Wartungspersonal erforderlich. Der Fehlerzustand stat_F kann dann nicht allein durch die Wartungsstation 12 bearbeitet werden. Die Wartungsstation 12 veranlasst deshalb zunächst die Verfahrensmaßnahme M3, wonach jeder weitere Arbeitseinsatz der Nutzeinheit 10 (z.B. durch entsprechende Steuersignale an die Nutzeinheit 10) blockiert wird. Diese Blockierung ist vorzugsweise durch Wartungspersonal im Rahmen der fehlerbezogenen Bearbeitung der Nutzeinheit 10 wieder aufhebbar. Außerdem veranlasst die Wartungsstation 12 eine Verfahrensmaßnahme M4, der zufolge eine spezifische Information M_info ausgegeben wird. Diese Information M_info wird z.B. optisch und/oder akustisch über eine Anzeigeeinheit ausgegeben und richtet sich an die in Betracht kommenden Personen, z.B. Fahrer, Anwender, Wartungspersonal. Die Information M_info beinhaltet vorzugsweise einen Hinweis auf die erforderliche fehlerbezogene Bearbeitung der Nutzeinheit 10 durch Wartungspersonal.

## Patentansprüche

1. Verfahren zur Überprüfung eines Fehlerzustandes (stat_F) einer mobilen Nutzeinheit (10) durch eine Wartungsstation (12), wobei
- einen Fehlerzustand (stat_F) der Nutzeinheit (10) repräsentierende Zustandsdaten (D_stat) generiert und als Fehlerdaten (D_F) abgespeichert werden,
- die Fehlerdaten (D_F) bezüglich unterschiedlicher Fehlerklassen (F1, F2, F3) klassifiziert werden,
- anhand der Klassifizierung eine zutreffende Fehlerklasse (F1, F2, F3) ermittelt wird, und
- in Abhängigkeit von der ermittelten Fehlerklasse (F1, F2, F3) eine Verfahrensmaßnahme (M1, M2, M3, M4) für die Nutzeinheit (10) veranlasst wird.

2. Verfahren nach Anspruch 1, **dadurch gekennzeichnet, dass** mindestens eine der folgenden Fehlerklassen vorgesehen ist:
- keine fehlerbezogene Bearbeitung der Nutzeinheit (10) erforderlich (F1),
- fehlerbezogene Bearbeitung der Nutzeinheit (10) durch die Wartungsstation (12) erforderlich (F2),
- fehlerbezogene Bearbeitung der Nutzeinheit (10) durch Wartungspersonal erforderlich (F3).

3. Verfahren nach einem der vorhergehenden Ansprüche, **dadurch gekennzeichnet, dass** mindestens eine der folgenden Verfahrensmaßnahmen vorgesehen ist:
- die Nutzeinheit (10) wird für einen weiteren Arbeitseinsatz freigegeben (M1),
- der Fehlerzustand (stat_F) wird in der Wartungsstation (12) und/oder durch die Wartungsstation (12) bearbeitet (M2),
- ein weiterer Arbeitseinsatz der Nutzeinheit (10) wird blockiert (M3).

4. Verfahren nach einem der vorhergehenden Ansprüche, **dadurch gekennzeichnet, dass** die Wartungsstation (12)
- die Klassifizierung (F1, F2, F3) der Fehlerdaten (D_F) durchführt, und/oder
- die Verfahrensmaßnahme (M1, M2, M3, M4) veranlasst.

5. Verfahren nach einem der vorhergehenden Ansprüche, **dadurch gekennzeichnet, dass** die Fehlerdaten (D_F)
- in einem Fehlerspeicher (14) der Nutzeinheit (10) abgespeichert werden, und/oder
- in einer Datenverarbeitungseinheit (20) der Wartungsstation (12) klassifiziert werden.

6. Verfahren nach einem der vorhergehenden Ansprüche, **dadurch gekennzeichnet, dass**
- die Nutzeinheit (10) eine Datenschnittstelle (16) zur Übertragung von Fehlerdaten (D_F) an die Wartungsstation (12) aufweist, und
- die Wartungsstation (12) eine Kommunikationsschnittstelle (18) zum Empfangen von Fehlerdaten (D_F) aufweist.

7. Verfahren nach einem der vorhergehenden Ansprüche, **gekennzeichnet durch** ein Nutzfahrzeug als mobile Nutzeinheit (10) .

8. Verfahren nach Anspruch 7, **dadurch gekennzeichnet, dass** das Nutzfahrzeug (10) ein land- oder forstwirtschaftliches Fahrzeug ist.

9. Verfahren nach Anspruch 7 oder 8, **dadurch gekennzeichnet, dass** das Nutzfahrzeug (10) ein autonomes Fahrzeug ist.
